(19) Europäisches Patentamt
European Patent Office
Office européen des brevets

(11) **EP 2 142 686 B1**

(12) **EUROPEAN PATENT SPECIFICATION**

(45) Date of publication and mention
of the grant of the patent:
**12.12.2018 Bulletin 2018/50**

(51) Int Cl.:
***C30B 13/26*** *(2006.01)*     ***C30B 13/32*** *(2006.01)*
***C30B 29/06*** *(2006.01)*

(21) Application number: **07722699.1**

(22) Date of filing: **13.04.2007**

(86) International application number:
**PCT/DK2007/050044**

(87) International publication number:
**WO 2008/125104 (23.10.2008 Gazette 2008/43)**

(54) **METHOD FOR PRODUCING A SINGLE CRYSTAL**

VERFAHREN ZUR HERSTELLUNG EINES EINKRISTALLS

PROCÉDÉ POUR PRODUIRE UN MONOCRISTAL

(84) Designated Contracting States:
**AT BE BG CH CY CZ DE DK EE ES FI FR GB GR HU IE IS IT LI LT LU LV MC MT NL PL PT RO SE SI SK TR**

(43) Date of publication of application:
**13.01.2010 Bulletin 2010/02**

(73) Proprietor: **Topsil GlobalWafers A/S
3600 Frederikssund (DK)**

(72) Inventors:
• **VAABENGAARD, Per
  DK-4070 Kirke-Hyllinge (DK)**
• **NIELSEN, Anne
  DK-3390 Hundested (DK)**
• **LARSEN, Theis, Leth
  DK-2860 Søborg (DK)**
• **PETERSEN, Jan, Eyving
  DK-3600 Frederikssund (DK)**
• **JENSEN, Leif
  DK-3600 Frederikssund (DK)**

(74) Representative: **AWA Denmark A/S
Strandgade 56
1401 Copenhagen K (DK)**

(56) References cited:
**EP-A1- 0 504 929        EP-A1- 0 629 719
DD-A1- 263 310          US-A- 4 851 628
US-A1- 2003 024 469    US-A1- 2003 192 470**

Remarks:
The file contains technical information submitted after the application was filed and not included in this specification

## Description

The present invention relates to a method to produce single crystals. In particular it relates to a method to produce single crystals of silicon of uniform resistivity across a cross-sectional plane essentially perpendicular to the direction of growth in a float-zone process.

Background art

Single crystal rods of semiconductor materials, such as silicon, are typically produced using one of two general methods, the Czochralski (CZ) method or the float-zone (FZ) method. Both of these are well-known and rely upon the formation of a single crystal during resolidification of molten material. However, neither of the processes is perfect as it is problematic to control the crystallisation in the interface between molten and solid material. This is especially true for silicon doped with phosphorus or boron. There is an increasing need for wafers, produced from monocrystalline rods, which are free of dislocations or errors in the crystal structure. The occurrence of imperfections in rods of single crystals increases with the diameter of the rod produced, and thus there is a demand for methods to improve the control over the crystallisation. The quality of the single crystal can be characterised by the resistivity of the material with a homogenous resistivity throughout the cross-section of the rod indicating high quality.

It has long been known that magnetic fields may be beneficial to the crystallisation as suggested by de Leon, Guldberg and Sailing (1981, Journal of Crystal Growth, 55: 406-408). In this case magnetic fields parallel to the direction of growth (i.e. axially oriented magnetic fields) were applied in a conventional FZ process. However, only narrow (<50 mm diameter) rods were tested and whether the principles are easily scaleable is not clear from their results.

A first attempt at employing magnetic fields commercially was described in DD 263 310. Herein, magnetic fields were applied laterally in both CZ and FZ methods to achieve improved crystal structures in the produced silicon rods.

Another two examples of applying magnetic fields perpendicularly to the direction of crystal growth in FZ processes are apparent in DE 100 51 885 and DE 102 16 609. In both cases the magnetic fields are rotated in a rotational direction opposite to that of the crystal rod. This putatively yields better control of the solidification.

DE 102 59 588 discloses a CZ method in which a magnetic field is applied to the crucible containing molten silicon so that the field is best described as parallel to the direction of crystal growth though it cannot be said to be uniform.

DE 196 17 870 describes an approach to applying axial magnetic fields to silicon crystals manufactured in a FZ process using permanent magnets. Considering the magnetic field strengths readily achievable with current day permanent magnets this may seem like an attractive approach. However, the high temperature necessary to melt silicon is expected to limit this approach as permanent magnets tend to become demagnetised at temperatures expected in the vicinity of a zone of molten silicon.

EP 0 504 929 and EP 0 629 719 both relate to applying axial magnetic fields to a silicon rod growing to monocrystallinity in a FZ process. Both of these suggest to obtain magnetic fields by applying a direct current to a solenoid coil surrounding the silicon rod, although EP 0 629 719 further discusses including a magnetic field being perpendicular to the direction of growth of the crystal. The silicon rods of EP 0 504 929 and EP 0 629 719 are rotated slowly during the formation of the single crystal.

Both US2003/0024468 and US2003/0024469 employ modified FZ processes in the preparation of single crystal silicon rods. The modifications lie in it that instead of using a traditional, monodirectional rotation of the silicon rods the rotation follows a pattern with alternating rotational directions. This added complexity putatively decreases the number of dislocations in the final crystal.

The present invention aims at providing a single crystal having highly homogenous electrical characteristics across the entire cross-section. Notably the object of the invention is to provide a method for obtaining a single crystal which may be sliced into wafers having only minor differences between resistivities measured at various locations on the wafer.

Disclosure of the invention

The present invention relates to a method for producing a single crystal as disclosed in claim 1.

The method of the present invention is of a type commonly known as float-zone (FZ) processes. However, the advantages obtained using the method in a FZ process may also be available to a method based on a Czochralski-type (CZ) process. Thus, applying a magnetic field to the melt in a crucible in a CZ process while simultaneously rotating the crystal in a pattern alternating between clockwise and counter-clockwise rotational directions is expected to improve the uniformity of the single crystal compared to known processes.

The method of the present invention is useful for producing single crystals of silicon, although single crystals of other semiconductor materials may also be produced using the method. Referring to the Periodic Table of Elements, these include materials such as an element or a mixture of elements selected from single elements of group IV, pairs of elements from group IV, pairs of elements from group III and group V, pairs of elements from group II and group VI, and pairs of elements from group IV and group VI. More specifically, the semiconducting material may be selected from the group consisting of silicon, germanium, carbon and SiC, or combinations thereof.

According to a certain aspect of the invention, the silicon single crystals may be doped with either phosphorus or boron. The dopant may be provided in the polycrystalline rod or be added as a gas to the melting region.

Single crystals produced using the method of the present invention may be formed from a single crystal seed in either <111> or <100> orientation. Other orientations of the crystal, such as <110> may be suitable for certain applications and are included in the present invention.

The magnetic field which is essential to the method of the current invention may be created using any appropriate means, however in a preferred embodiment the axially oriented magnetic field is created by passing a direct electric current through a solenoid coil arranged to surround the molten zone. In a preferred embodiment the flux density of the axial magnetic field is in the range from 0.005 to 0.015 T, in a more preferred embodiment the flux density is in the range from 0.008 to 0.0125 T. However, the advantages of the method of the present invention may also be realised by applying a magnetic field of a higher flux density, e.g. up to approximately 0.05 T, to the molten zone.

The magnetic field is preferably essentially axially oriented to the polycrystalline rod. Preferably, the magnetic field is provided with a direction and strength sufficient to break the stirring process to a desired degree.

It is an important characteristic of the method of the present invention that the growing single crystal is rotated in an alternating fashion so that the rotational directions alternate between clockwise and counter-clockwise rotations. The rotational rate of the clockwise rotation may be the same as that of the counter-clockwise rotation, or they may be different.

In a preferred embodiment the rotational rates are essentially equal, and have a value in the range of 10 to 18 rpm; more preferably the rotational rates are in the range of 12 to 15 rpm. Using higher or lower rotational rates, though, may also be advantageous. The change in direction of rotation is generally kept relatively fast. Thus, the change in direction may last from 0.1 to 2 s, suitably 0.2 to 0.6 s.

The duration of the clockwise rotation employed in the method of the present invention may be essentially equal to that of the counter-clockwise rotation, or the two durations may be different. In the event the duration of the clockwise and counter-clockwise rotation is equal, it is preferred that the rate of rotation is different to prevent inversion points stacked immediately above each other in the formed single crystal rod.

The duration of each of the clockwise or the counter-clockwise rotations may be in the range from 2 to 10 seconds, though durations between around 4 to around 6 seconds are preferred. The durations of the rotations in the two rotational directions are not limited to this range, however as durations longer than 10 seconds may be advantageous in the production of certain types and diameters of single crystals. The growing single crystal is typically rotated in a plane of rotation essentially perpendicular to the direction of growth of the single crystal.

The growth rate of the single crystal is generally referred to as the drawing rate. According to an aspect of the invention, the growing single crystal is pulled by a rate of 2 to 5 mm/min. The produced single crystal generally has a diameter in the range of 75mm to 350mm, suitably in the range of 100mm to 220mm.

The method of the present invention may be employed with short or long polycrystalline rods. In case the length of the rod is considerably longer than its diameter it is preferred to move the molten zone towards one end of the polycrystalline rod by either moving the polycrystalline rod relative to the heating region, or by moving the heating region relative to the polycrystalline rod. In certain embodiment it is desired to fix the rotation of the polycrystalline rod, while in other embodiments it is advantageous to rotate the polycrystalline rod at a rate of rotation of 0.5 to 40 rpm.

In the method of the present invention the orientation of the polycrystalline rod may be in any direction. However, the polycrystalline rod is preferably essentially vertically oriented for obtaining a uniformly distributed melt.

Not part of this invention is an apparatus for producing a single crystal. This apparatus comprises a heater for creating a molten zone in a polycrystalline rod, a current conductor arranged as a coil surrounding the heater, an upper shaft for suspending the polycrystalline rod, and a lower shaft for supporting the growing single crystal, wherein the lower shaft are capable of conveying to the growing single crystal a clockwise rotational direction in a first time period and a counter-clockwise rotational direction in a second time period.

The heater comprises a single-turn high-frequency induction coil, suitably prepared from copper. The current conductor of the coil is preferably made from copper or aluminium. In another preferred embodiment the shafts are further capable of conveying vertical movement to the polycrystalline rod and the growing single crystal. The upper shaft may either be capable of rotationally fixing the polycrystalline rod or capable of conveying a rotation of the polycrystalline rod.

Brief description of the figures

Fig. 1 Shows a schematic illustration of an apparatus which apparatus is suitable for producing single crystals according to the method of the present invention.
Fig. 2 Shows an exemplary rotational pattern useful for the method of the present invention.
Fig. 3 Shows relative resistivity values obtained for silicon single crystals produced according to the method of the present invention.

Detailed description of the invention

The present invention is related to the semiconductor area. More specifically it is related to the production of single crystal rods. The term "rod" is commonly used to describe a piece of a substance being considerably longer than its width. However, in the context of the present invention a rod may also be as short as or shorter than its width. In terms of the present invention a rod is of a generally round cross-section, so that the width may be described as a diameter. Moreover, the polycrystalline rods used as raw materials in the method of the present invention are not necessarily straight, but may also be slightly curved to have a marginal semblance of a banana in terms of shape.

In terms of the present invention the word "polycrystalline" is not particularly limiting, but is intended to cover material of various types of crystallinity the quality of which may be improved by processing it in the method of the present invention. Thus for example, it may be advantageous to reprocess a "single crystal" produced in the method of the present invention. Likewise the term "single crystal" is, without limitations, intended to describe the result of processing a "polycrystalline rod" using the method of the present invention.

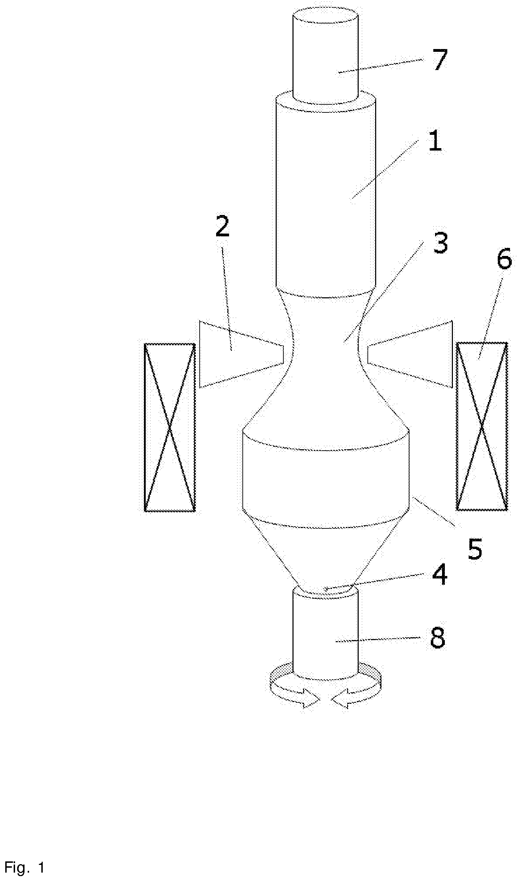

The apparatus which is useful for performing the method of the present invention is illustrated schematically in Fig. 1. Thus, a polycrystalline rod (1) is passed through a heating region including, e.g. a watercooled, copper single-turn high-frequency induction coil (2), to create a molten zone (3). Upon cooling and solidification of the molten zone on a single crystal seed (4) formation and growth of the single crystal (5) will proceed. During the course of the process, a magnetic field essentially axially oriented to the polycrystalline rod is imposed on the molten zone with the aid of e.g. a solenoid coil (6) surrounding the molten zone. The polycrystalline rod is suspended from an upper shaft (7) and the growing single crystal is supported by a lower shaft (8). The at least the lower shaft is capable of conveying rotation to the growing single crystal and optionally the polycrystalline rod, so they may be rotated in a pattern alternating between clockwise and counter-clockwise rotational directions in a plane of rotation essentially perpendicular to the direction of growth of the single crystal while simultaneously being capable of moving the molten zone from one end of the polycrystalline rod to the other.

The coil employed for creating the magnetic field can appropriately consist of a copper or aluminium wire being wound around the molten zone in a number of windings. Thus, when a direct electrical current is passed through the wire a magnetic field is formed in the centre of the coil essentially parallel to the polycrystalline rod and the growing single crystal. The magnetic field may also be formed by using an alternating current, usually having a frequency in the range of 50 Hz to 100 kHz.

A frequency below 50 Hz may be considered for certain applications. However at low frequencies, the melt has a tendency to destabilise.

Flux densities of magnetic fields formed in solenoid coils are easily calculated from well-known physical laws about electromagnetism, but generally speaking the higher the number of windings and the higher the applied current (in Ampere) the higher the flux density achieved. An appropriately designed apparatus may have sufficiently many windings to impose magnetic flux densities of up to approximately 0.05 T; by using a solenoid coil to create the magnetic field the flux density may be controlled easily simply by adjusting the applied current. Additionally the wires may be of sufficiently high diameter to minimise energy consumption during generation of the magnetic field.

While a magnetic field presently is preferred to be formed by passing an electric current through a coil, permanent magnets are contemplated for certain applications.

According to a certain aspect of the invention the lines of flux are essentially axially oriented, ie. the lines of flux are essentially parallel to the longitudinal dimension of the polycrystalline rod in at least a part of the melt zone. Thus, the flux lines may be curved for some parts of the melt zone and essentially parallel in another part. By essentially parallel is intended, that the lines of flux may deviate from the axis of the rod with up to 10 degrees. The desired pattern of flux lines may be obtained by raising or lowering a coil relative to the molten zone. While a solenoid coil is generally preferred it might be desired to use other types of coils like Helm holtz coil, Maxwell coil, or bifilar coil.

According to another aspect of the invention, the flux lines are essentially radial, ie horizontally for a vertical polycrystalline rod.

A polycrystalline feed rod may be obtained through any appropriate process. According to a first process the polycrystalline rod is obtained by a CZ-process. According to a second process the polycrystalline rod is obtained by a so-called Siemens-type process in which a volatile compound comprising eg. silicon is decomposed to deposit silicon on a wire. In a third process the single crystal is prepared by a double pass process, in which a crude silicon-containing material is treated by a FZ-process in a first pass and in a second pass treated by the method of the present invention. The FZ-process of the fist pass may be identical to or different from the method of the present invention.

The polycrystalline rod may be rotational fixed or may be allowed to rotate. In the instances, in which the polycrystalline rod is allowed to rotate it may rotate in a clockwise direction, a counter-clockwise direction or alternating between the clockwise and counter-clockwise direction.

A typical polycrystalline feed rod for use in the method of the present invention has a diameter of 90-160 mm and has a length of up to 2,5 m. The end of the rod is normally ground or otherwise processed into a conical shape prior to the processing. In the present method, the conical bottom end of such a polycrystalline rod is initially preheated and placed in the centre of the water cooled, single-turn copper high-frequency induction coil. A conducting susceptor, such as graphite, is then placed underneath the polycrystalline rod with a minimal gap. When a current is applied to the induction coil, an electrical eddy current is induced in the susceptor and the temperature of the susceptor increases. The generated heat is then transferred to the polycrystalline rod by radiation. Once the portion of polycrystalline material in close proximity to the susceptor starts to glow, the eddy current can be induced in this segment of material by the high-frequency energy. The graphite susceptor is no longer needed and is removed from the induction coil. The heat is continuously applied until the conical segment of the polycrystalline rod melts. Subsequently, a single crystal seed is dipped into the molten material from below.

Once the seed is wetted by the molten material, the growth of a crystal can be initiated by lowering the seed. The polycrystalline rod is also lowered, but at a much lower rate. Dislocation-free growth should be initiated during the seeding process by using high pull rates. Once the dislocation-free structure is observed (as seen from the appearance of clearly visible side facets), the ratio of pull rates between the seed and polycrystalline rod is gradually decreased so that the crystal diameter will gradually increase. Single crystals produced using the method of the present invention may be from about 75 to about 450 mm in diameter, though the diameters are typically of approximately 100 mm to 200 mm.

The single crystal may be doped with small amounts of impurities that change the electrical properties. Examples of dopants belong to the group III or group V of the periodic table of elements. Boron, arsenic, phosphorus and occasionally gallium are generally used to dope silicon. Boron is the p-type dopant of choice for silicon integrated circuit production, since it diffuses at a rate which makes junction depths easily controllable. Phosphorus is a n-type dopant and is typically used for bulk doping of silicon wafers, while arsenic is used to diffuse junctions, since it diffuses more slowly than phosphorus and is thus more controllable. Boron may be introduced in the crystal structure by growing the crystal in an atmosphere of diborane and phosphorous may be incorporated in the structure by growing the single crystal in an atmosphere of phosphine.

The frequency applied to the high-frequency induction coil is a process parameter, as the penetration depth is dependent on the frequency. It has been suggested that the optimum frequency is between 2 and 3 MHz. When the frequency is below 500 kHz, an undesirable surface melting may occur. On the other hand, a frequency higher than 3 MHz increases the risk of arcing.

A factor for successful crystal growth is maintaining the stability of the molten zone. The zone is stable when the inward pressure of the zone is greater than the outward pressure. The inward pressure includes surface tension, cohesion between the solid and liquid, and electromagnetic pressure. The latter two terms are relatively small as compared to the surface tension. The outward pressure mainly includes the hydrostatic pressure resulting from the gravitational force of the molten zone. The hydrostatic pressure is directly proportional to the zone height. Therefore, the molten zone should be kept narrower than the rod diameter.

The single crystal rod may be pulled by any appropriate rate. Generally, it is desired to obtain a relatively high drawing rate due to process economy. The drawing rate is dependent on i.a. the diameter of the formed single crystal. Thus, higher drawing rates may be obtained for small diameters. Drawing rates of 5 mm/min and below are generally suitable for the present method.

According to the present invention the combined application of an axial magnetic field and an alternating rotational pattern improves the uniformity of the single crystal compared to previously known techniques. The uniformity of a single crystal may be expressed in terms of the relative resistivity value (*RRV*). This value is calculated as the ratio between the difference of the highest and the lowest resistivity values to that of the lowest, i.e.:

$$RRV = \frac{R_{\max} - R_{\min}}{R_{\min}}$$

Thus, the *RRV* expresses the cross-sectional uniformity of a single crystal and can therefore be used as an indicator for the quality of wafers sliced from a crystal.

It is presently believed that by combining the application of a magnetic field and an alternating, rotational pattern of the crystal, the magnetic field will assist in the stabilisation of the centre of the molten zone. Experimental data reported herein shows that the combination leads to improvements in the uniformity of the single crystal that could not be obtained using either an alternating, rotational pattern or an axial magnetic field alone.

The advantages of the method of the present invention are particularly pronounced for producing silicon single crystals doped with either boron or phosphorus, as a very uniform distribution of such dopants across the cross-section of a crystal may be ensured by the improved crystallisation.

Exam pies

Exam ple 1

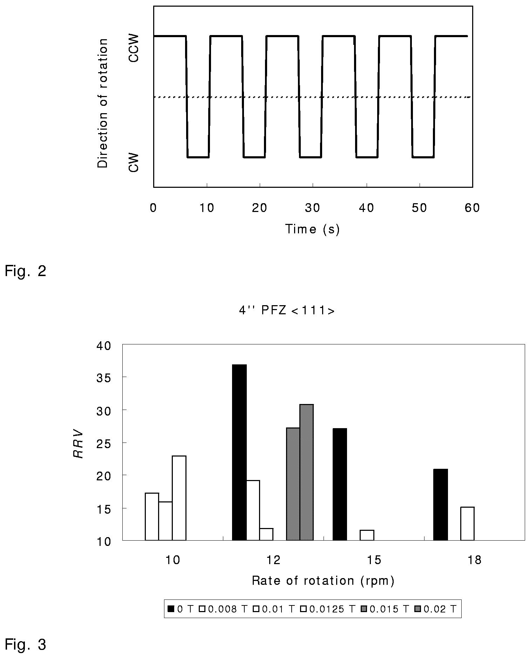

A silicon monocrystal was prepared according to the method of the current invention. A crystal of 100 mm diameter (4") was pulled from a polycrystalline rod with a <111> orientation of the crystal seed using FZ principles. Static magnetic flux densities (from 0 up to 0.02 T) were applied to the molten zone in a direction essentially parallel to the growth direction of the crystal (i.e. parallel to the length axis of the rod). Magnetic fields were created by passing a direct current through a copper coil wound around the crystal allowing easy control of the magnetic flux density. In all experiments the rotation of the crystal was alternated between clockwise and counter-clockwise rotations of 4 and 6 seconds durations, respectively. The change in direction of rotation lasted a maximum of 0.3 s. The pattern for the alternating rotation is illustrated in Fig. 2. Rotational rates of 10 to 18 rpm were tested. In all experiments the movement rate of the rod was 2.8 mm/min.

The results from the experiments are shown in Fig. 3. In this figure the data is presented as the relative resistivity value (*RRV*). A uniform resistivity across the diameter of the silicon monocrystal is indicated by low *RRV* values. As seen in Fig. 3, the use of magnetic flux densities of 0.01 T (100 Gauss) provided the lowest *RRV* irrespective of the rate of rotation. However, a rate of rotation of 12 or 15 rpm led to superior results for magnetic flux densities of 0.01 T, than was obtained using higher or lower rotational rates.

**Claims**

1. A method for producing a silicon single crystal comprising the steps of
   passing a polycrystalline silicon rod through a heating region to create a molten zone,
   applying a magnetic field to the molten zone, which magnetic field is axially oriented to the polycrystalline silicon rod and created by passing a direct electric current through a solenoid coil arranged to surround the molten zone, and
   inducing formation and growth of a silicon single crystal upon solidification of the molten material on a silicon single crystal seed,
   **characterised in that** the growing silicon single crystal is rotated in a pattern alternating between clockwise and counter-clockwise rotational directions **in that** the flux density of the axial magnetic field is in the range from 0.005 to 0.015 T, and **in that** the diameter of the pulled silicon single crystal is in the range from 75 mm to 350 mm.

2. The method according to claim 1, wherein the polycrystalline silicon rod is rotated at a rate of rotation of 0.5 to 40 rpm.

3. The method according to any of the claims 1 or 2, wherein the rotational rates of the clockwise and counter-clockwise rotations are in the range of 10 to 18 rpm.

4. The method according to any of the claims 1 to 3, wherein the durations of the clockwise and counter-clockwise rotations each are in the range from 2 to 10 seconds.

5. The method according to any of the claims 1 to 4, comprising a relative movement between the polycrystalline silicon rod and the heating region thereby causing a movement of the molten zone towards one end of the polycrystalline silicon rod.

6. The method according to any of the claims 1 to 5, further comprising the step of slicing the produced silicon single crystal into one or more wafers.

**Patentansprüche**

1. Verfahren zur Herstellung eines Silicium-Einkristalls, das folgende Schritte umfasst:

   Führen eines polykristallinen Siliciumstabs durch einen Aufheizbereich zur Bildung einer schmelzflüssigen Zone,
   Anlegen eines Magnetfelds an die schmelzflüssige Zone, wobei das Magnetfeld axial zu dem polykristallinen Siliciumstab orientiert wird und durch Durchleiten eines Gleichstroms durch eine Magnetspule, die so angeordnet ist, dass sie die schmelzflüssige Zone umgibt, erzeugt wird, und
   Induzieren von Bildung und Wachstum eines Silicium-Einkristalls beim Festwerden des schmelzflüssigen Materials auf einem Silicium-Einkristall-Keim,
   **dadurch gekennzeichnet, dass** der wachsende Silicium-Einkristall in einem zwischen rechtsläufiger und linksläufiger Drehrichtung alternierenden Muster gedreht wird, dass die Flussdichte des axialen Magnetfelds im Bereich von 0,005 bis 0,015 T liegt und dass der Durchmesser des gezogenen Silicium-Einkristalls im Bereich von 75 mm bis 350 mm liegt.

2. Verfahren nach Anspruch 1, bei dem der polykristalline Siliciumstab mit einer Drehgeschwindigkeit von 0,5 bis 40 U/min gedreht wird.

3. Verfahren nach Anspruch 1 oder 2, bei dem die Drehgeschwindigkeiten der rechtsläufigen und linksläufigen Drehungen im Bereich von 10 bis 18 U/min liegen.

4. Verfahren nach einem der Ansprüche 1 bis 3, bei dem die Dauern der rechtsläufigen und linksläufigen Drehungen jeweils im Bereich von 2 bis 10 Sekunden liegen.

**5.** Verfahren nach einem der Ansprüche 1 bis 4, umfassend eine relative Bewegung zwischen dem polykristallinen Siliciumstab und dem Aufheizbereich, wodurch eine Bewegung der schmelzflüssigen Zone zu einem Ende des polykristallinen Siliciumstabs hin verursacht wird.

**6.** Verfahren nach einem der Ansprüche 1 bis 5, ferner umfassend den Schritt des Schneidens des hergestellten Silicium-Einkristalls in einen oder mehrere Wafer.

**Revendications**

**1.** Procédé de production d'un monocristal de silicium comprenant les étapes de
passage d'une tige de silicium polycristallin à travers une région de chauffage pour créer une zone fondue, application d'un champ magnétique à la zone fondue, ledit champ magnétique étant axialement orienté vers la tige de silicium polycristallin et généré par passage d'un courant électrique continu à travers une bobine a solénoïde agencée de façon à entourer la zone fondue, et induction de la formation et de la croissance d'un monocristal de silicium après solidification du matériau fondu sur un germe de monocristal de silicium, **caractérisé en ce que** le monocristal de silicium en croissance est tourné selon un motif alterné entre des directions de rotation horaire et antihoraire et **en ce que** la densité de flux du champ magnétique axial est dans la plage de 0,005 à 0,015 T, et **en ce que** le diamètre du monocristal de silicium formé est dans la plage de 75 mm à 350 mm.

**2.** Procédé selon la revendication 1, dans lequel la tige de silicium polycristallin est tournée à une vitesse de rotation de 0,5 à 40 tours/min.

**3.** Procédé selon l'une quelconque des revendications 1 ou 2, dans lequel les vitesses de rotation des rotations horaire et antihoraire sont dans la plage de 10 à 18 tours/min.

**4.** Procédé selon l'une quelconque des revendications 1 à 3, dans lequel les durées des rotations horaire et antihoraire sont chacune dans la plage de 2 à 10 secondes.

**5.** Procédé selon l'une quelconque des revendications 1 à 4, comprenant un mouvement relatif entre la tige de silicium polycristallin et la région de chauffage de façon à causer un déplacement de la zone fondue vers une extrémité de la tige de silicium polycristallin.

**6.** Procédé selon l'une quelconque des revendications 1 à 5, comprenant en outre l'étape de sectionnement du monocristal de silicium produit en une ou plusieurs tranches.

Fig. 1

Fig. 2

4'' PFZ <111>

Fig. 3

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- DD 263310
- DE 10051885
- DE 10216609
- DE 10259588
- DE 19617870
- EP 0504929 A
- EP 0629719 A
- US 20030024468 A
- US 20030024469 A

**Non-patent literature cited in the description**

- **DE LEON ; GULDBERG ; SAILING.** *Journal of Crystal Growth,* 1981, vol. 55, 406-408